# EUROPEAN PATENT SPECIFICATION

(11) **EP 1 142 113 B1**
(45) Date of publication and mention of the grant of the patent: **07.06.2006**
(21) Application number: 00908219.9
(22) Date of filing: 06.01.2000
(51) Int. Cl.: H03K 3/00

(54) **DEFLECTION CIRCUITS COUPLED VIA A FILTER**
ABLENKSCHALTUNGEN, DIE ÜBER EINEN FILTER GEKOPPELT SIND
CIRCUITS DE DEVIATION COUPLES VIA UN FILTRE

(30) Priority: 12.01.1999 US 115709 P; 17.12.1999 US 465617
(43) Date of publication of application: 10.10.2001
(73) Proprietor: Thomson Licensing, 92100 Boulogne-Billancourt (FR)
(72) Inventor: TRUSKALO, Walter, Titusville, NJ 08560 (US); SHOUSE, John, Felix, Jr., Indianapolis, IN 46260 (US)
(74) Representative: Rossmanith, Manfred
(86) International application number: PCT/US2000/000307
(87) International publication number: WO 2000/041519

(56) References cited:
- EP-A- 0 384 293
- EP-A- 0 451 805
- US-A- 3 894 268
- US-A- 4 794 307
- US-A- 5 304 898

## Description

### Field of the Invention

The invention relates to raster correction circuits of a video display.

### Background

In a cathode ray tube (CRT) of a video display, a raster is formed by deflecting an electron beam across a phosphor screen. Each electron beam is deflected in a horizontal direction by a magnetic field produced by a horizontal deflection coil by a horizontal-rate sawtooth current Likewise, the electron beam is simultaneously deflected in a vertical direction by a magnetic field produced by a vertical deflection coil by a vertical-rate sawtooth current. The result is a negatively-sloped, or "downhill", scan line as the electron beam is deflected from left to right to form the CRT's raster. In a typical cathode ray tube used in a color television receiver and having, for example, a screen width of approximately 723 mm and a screen height of approximately 538 mm, a horizontal scan line may drop a distance of approximately 2.4 mm from a perfectly horizontal position in one field. This downhill scan effect introduces both orthogonality and parallelogram errors into the raster.

In a perfectly rectangular raster, horizontal and vertical center lines are orthogonal, or perpendicular to one another. Downhill scanning does not produce a perfectly rectangular raster and hence results in a non-orthogonal relationship between the horizontal and vertical center lines of the raster. Orthogonality error is a quantitative measure, expressed in units of radians or degrees, of the extent to which the horizontal and vertical center lines of a raster depart from orthogonality. The orthogonality error may be magnified at the left and right edges of the raster because the deflection sensitivity increases near the edges of the raster. As a result; the edges of the raster may tilt such that the raster has a generally parallelogram shape.

EP 0 808 058 A2 relates to a vertical deflection circuit with raster correction. A raster correction circuit substantially offsets the downward slope of the electron beam by modulating a vertical deflection current with an induced Horizontal-rate raster correction current, thereby substantially eliminating orthogonality and parallelogram errors in the raster.

EP 0384 293 A2 relates to an audio loading modulated side pincushion correction circuit. In the known circuit the audio load modulated side pincushion correction current serves to modulate a horizontal deflection current and is used to modulate a horizontal deflection current in order to compensate for both side pincushion distortion and dynamic audio load induced raster width distortion.

US Patent 5,304,898 relates to a high voltage generating circuit The known circuit comprises a flyback transformer having a primary winding and a secondary winding. The primary winding is supplied with pulses of a first frequency. A smoothing capacitor is connected across the secondary winding. An output line is connected to one terminal of the smoothing capacitor and a variation of high voltage on the output line is detected to generate compensating voltage pulses of a second frequency which is higher than the first frequency for compensating the variation of high voltage to supply the compensating voltage pulses to the other terminal of the smoothing capacitor. In the known arrangement a low pass filter serves to prevent compensating voltage pulses from being supplied to the secondary winding.

US Patent 3,894,268 is related to deflection circuit for a television receiver. A supply circuit containing rectifiers and filters is disposed between the horizontal and vertical stages for rectifying and filtering the horizontal-frequency a.c. voltage. The filter of the supply circuit is designed to oscillate at the frequency of the vertical deflection current and thereby directly modulate the current flowing in the horizontal deflection circuit to provide horizontal pincushion correction. Pincushion correction is enhanced by connecting a pair ofRC circuits in parallel with the vertical deflection coils, each RC circuit includes a diode so that one RC circuit conducts in one direction at the beginning of each vertical deflection period, and the other RC circuit conducts in the opposite direction at the end of each vertical deflection period so as to generate a sawtooth current which is superimposed on the current drawn from the horizontal final stage.

EP 0451 805 A2 relates to a raster size regulating circuit and provides for an arrangement that compensates for a tendency in a raster width of a display screen of a video or television to increase when a variation in a beam current occurs, decreases an amplitude of a deflection current to decrease in a nonlinear manner as a function of an increase in the beam current.

Elimination of both orthogonality and parallelogram errors in a raster can be obtained by providing a horizontal-rate modulation of a vertical deflection current for substantially offsetting the downhill scan effect caused by vertical deflection of the electron beam. A winding of a horizontal flyback transformer can be used to apply a horizontal retrace pulse voltage to a primary winding of a transformer. A secondary winding of the transformer can be coupled to a vertical deflection winding for providing a small horizontal rate sawtooth current to be superimposed on a vertical deflection current
Coupling back of the vertical current to the horizontal deflection circuit is reduced by the relatively large leakage of the transformer. Nevertheless, the residual vertical rate current, during vertical retrace, can still produce a disturbance at the top of the screen, immediately after vertical retrace. It may be desirable to further reduce the coupling back of the vertical current to the horizontal deflection circuit.

In carrying out an inventive feature, an R-C filter is interposed in a current path between the transformers. The R-C filter attenuates the coupled back vertical deflection current. Thereby, the addition of the R-C coupling filter prevents the vertical deflection current from affecting the horizontal deflection circuit.

### Summary of the Invention

A video display deflection apparatus, embodying an inventive feature, includes a first deflection circuit for generating a first deflection current at a first deflection frequency in a first deflection winding to vary a position of an electron beam in a first direction. A second deflection circuit is used for generating a second deflection current in a second deflection winding at a second deflection frequency to vary the position of the electron beam in a second direction. A filter couples the second deflection circuit to the first deflection winding to generate a corrective current in a current path formed by the first deflection winding at a frequency related to the second deflection frequency for providing raster error correction. The filter significantly attenuates parasitic signal coupling in an opposite direction, from the first deflection circuit to the second deflection circuit.

### BRIEF DESCRIPTION OF THE DRAWINGS

FIGURE 1 illustrates an arrangement for correcting orthogonality and parallelogram errors in a raster, including a filter, in accordance with an inventive feature;
FIGURES 2a and 2b illustrate waveforms useful for explaining the operation of the deflection system shown in FIGURE 1, when the filter is employed; and
FIGURES 3a and 3b illustrate waveforms useful for explaining the operation of the deflection system shown in FIGURE 1, when the filter is removed.

### DETAILED DESCRIPTION

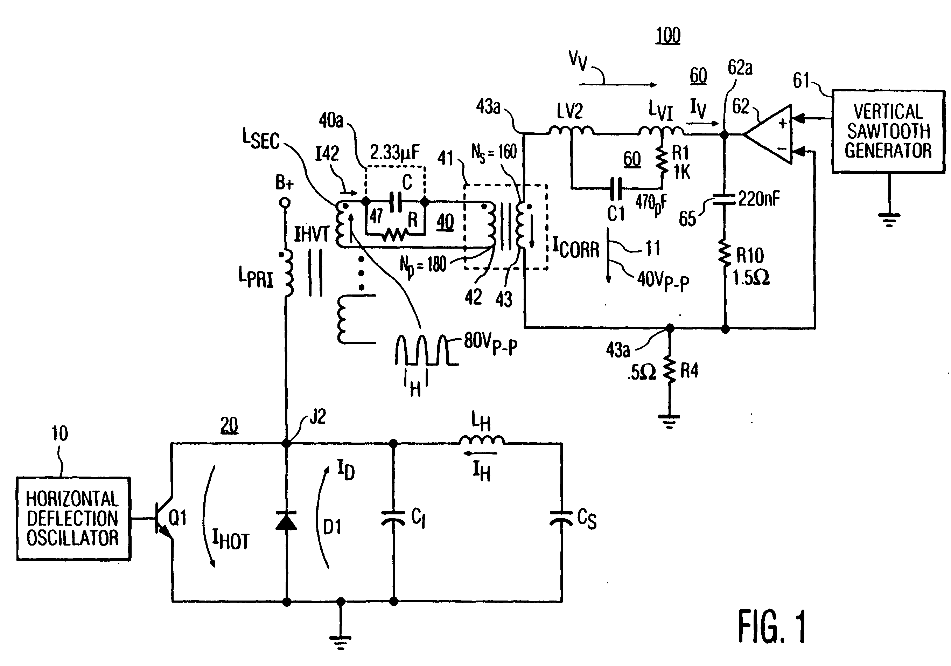

A deflection system 100 of FIGURE 1 provides deflection for a cathode ray tube, not shown, of a television receiver or a video display terminal. A B⁺ voltage is coupled to a conventional horizontal deflection circuit 20 through a primary winding L_{PRI} of a flyback transformer IHVT. A damper current I_{D} flows through a damper diode D1 to deflect an electron beam from a left edge of a raster to a center of the raster. A horizontal output transistor Q1 conducts a current I_{HOT} to deflect the electron beam from the center of the raster to a right edge of the raster. A horizontal deflection current I_{H} flowing through a horizontal deflection winding L_{H} may have a peak-to-peak amplitude of several amperes. A trace capacitor C_{S}, coupled in series with deflection winding L_{H} provides S-correction for the horizontal deflection current I_{H}.

A secondary winding L_{SEC} of flyback transformer IHVT is coupled via an R-C filter 40, embodying an inventive feature, to a primary winding 42 of a raster correction transformer 41. Transformer 41 has a secondary winding 43. Transformer 41 is wound on a ferrite slug core 1 " (2.54 cm) long x 0.399" (10.13 mm) diameter. Winding 43 has N_{S =} 60 turns, 5-strand Litz AWG#30 (0.2546 mm) wire, and winding 42 has N_{P} = 180 turns, AWG#29 (0.2859 mm) wire.

A horizontal-rate retrace pulse, not shown, produced in a conventional manner in deflection circuit 20, is transformer-coupled to secondary winding L_{SEC} of transformer IHVT to develop a horizontal-rate retrace pulse 12. Retrace pulse 12 is coupled via R-C filter 40, embodying an inventive feature, to winding 42 of transformer 41. Transformer 41 steps down a significant portion of horizontal-rate pulse 12 coupled through R-C filter 40 and developed in winding 42 according to transformer 41 turns ratio. Raster correction transformer 41 develops a stepped-down horizontal-rate pulse waveform 11 with a peak-to-peak voltage of approximately 40V p-p across secondary winding 43. Similarly, a horizontal raster correction current I_{CORR} is induced in secondary winding 43.

A direct current (DC) coupled vertical deflection circuit 60 includes a conventional vertical-rate sawtooth generator 61 that provides a vertical-rate sawtooth waveform to a non-inverting input of a conventional vertical output amplifier 62. Vertical output amplifier 62 may include a push-pull transistor output stage, not shown. Vertical output amplifier 62 drives vertical deflection windings L_{V1} and L_{V2}, coupled in series, with a vertical-rate sawtooth current I_{V}.

Vertical deflection windings L_{V1} and L_{V2} are also coupled in series with winding 43 of transformer 41 and with resistor R4. Current-sense resistor R4 generates a feedback voltage at an inverting input of vertical output amplifier 62 responsive to the vertical deflection current I_{V}. Except for the modulation provided by raster correction current I_{CORR} induced in secondary winding 43, vertical deflection circuit 60 generates current I_{V} in a conventional manner. Horizontal rate raster correction current I_{CORR} flows through both vertical deflection windings L_{V1} and L_{V2} to produce a magnetic field which opposes the aforementioned downhill scan effect.

For explanation purposes, assume that filter 40 is not used. Instead, assume that winding L_{SEC} of high-voltage transformer IHVT is coupled directly in parallel with winding 42 of transformer 41, as shown by a jumper conductor 40a.

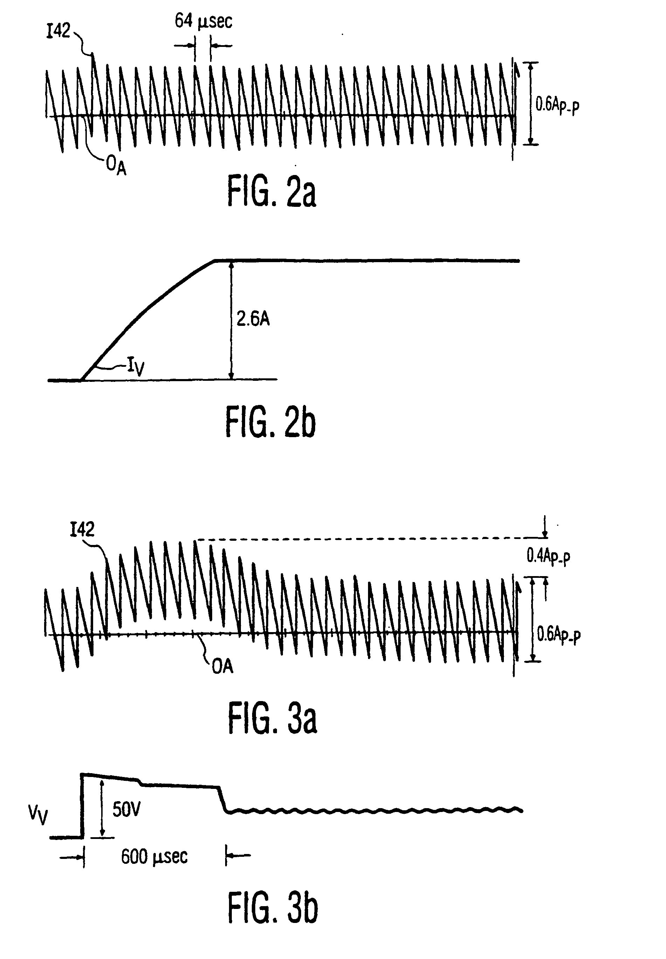

Vertical deflection current I_{V} flows through secondary winding 43 of transformer 41. During vertical retrace, a vertical pulse voltage V_{V} of FIGURE 3b, developed across windings L_{V1} and L_{V2} of FIGURE 1, produces a vertical rate current component in a current 142 of winding 42 of transformer 41. Vertical rate modulation of current 142 of FIGURE 3a, during the retrace portion of vertical pulse voltage V_{V} of FIGURE 3b, shifts the average value of current 142 in a vertical rate. Similar symbols and numerals in FIGURES 1, 3a and 3b indicate similar items or functions.

The vertical rate current component in current 142 of FIGURE 1 may be coupled back to horizontal deflection circuit 20 via transformer IHVT and, disadvantageously, may initiate ringing in horizontal deflection winding L_{H}. A resulting width disturbance can become visible on the display screen, not shown.

In carrying out an inventive feature, the coupling back from the vertical to the horizontal is reduced or eliminated by the addition of R-C filter 40 between winding L_{SEC} of transformer IHVT and winding 42 of transformer 41. This situation is demonstrated, when jumper conductor 40a in FIGURE 1 is removed and filter 40 is interposed. Capacitor C of filter 40 forms a low impedance for horizontal rate current component of current 142. Therefore, Capacitor C of filter 40 does not attenuate the horizontal rate current component of current 142. On the other hand, for the vertical rate current component of current 142, capacitor C forms a high impedance and acts as an attenuator. Thereby, coupling back, is advantageously, attenuated significantly.

The waveform of primary current 142 when R-C filter 40 is in circuit is shown in FIGURE 2a. In contrast to the waveform in FIGURE 3a, vertical deflection current I_{V} of FIGURE 2b, during vertical retrace, advantageously, does not produce any significant vertical rate current component in current 142 of FIGURE 2a. Similar symbols and numerals in FIGURES 1, 3a, 3b, 2a and 2b indicate similar items or functions. The elimination of the parasitic, back coupling effect in current 142 of FIGURE 2a from current I_{V} of FIGURE 2b, advantageously, eliminates the width artifact at the start of vertical scan.

A damping circuit 60 is formed by a resistor R1 and a capacitor C1, coupled in series. Circuit 60, is coupled between a center tap 21, approximately in the midpoint of vertical deflection windings L_{V1}, and a center tap 21, approximately, in the midpoint of vertical deflection windings L_{V2}.

The effectiveness of the injection of parallelogram/orthogonality error correction current I_{CORR} by winding 43 at an end terminal 43a of the vertical deflection windings L_{V1} and L_{V2}, that is remote from amplifier 62, is facilitated by installing damping circuit 60 formed by resistor R1 and capacitor C1. Damping circuit 60 increases the sensitivity of windings L_{V1} and L_{V2} to correction current I_{CORR}. Consequently, single ended drive is sufficient.

## Claims

1. A video display deflection apparatus, comprising:
a vertical deflection circuit (20) for generating a vertical deflection current at a vertical deflection winding (LV) to vary a position of an electron beam in a vertical direction;
a horizontal deflection circuit (60) for generating a horizontal deflection current in a horizontal deflection winding at a horizontal deflection frequency to vary the position of said electron beam in a horizontal direction; and **characterized by**:
a filter (40) for coupling said horizontal deflection circuit to said vertical deflection winding, said filter (40)being interposed in a current path between said vertical deflection circuit (60) and said horizontal deflection circuit (20), to generate a corrective current in a current path formed by said vertical deflection winding (LV) at a frequency related to said horizontal deflection frequency for providing raster error correction, said filter (40) significantly attenuating parasitic signal coupling in an opposite direction, from said vertical deflection circuit (60) to said horizontal deflection circuit (20).

2. The deflection apparatus according to claim 1, further **characterized in that** said filter for generating a corrective current generates a corrective current that substantially reduces a downward slope imparted to said electron beam as said electron beam is deflected between first and second lateral edges of said raster.

3. The deflection apparatus according to claim 1, further **characterized in that** said filter for generating a corrective current generates a corrective current that corrects at least one of parallelogram and orthogonality errors.

4. The deflection apparatus according to claim 1 further **characterized in that** said filter for generating a corrective current generates a corrective current that has a horizontal scanning rate.

5. The deflection apparatus of claim 1 further **characterized in that** said vertical deflection circuit provides vertical deflection and includes a winding of a first transformer and said horizontal circuit includes a winding of a horizontal flyback transformer and wherein said filter is coupled in a current path between said transformers.

6. The deflection apparatus according to claim 1 further **characterized in that** said filter comprises a capacitor having a low impedance at said horizontal deflection frequency for coupling a horizontal rate signal from said horizontal to said vertical deflection apparatus without significant attenuation and a high impedance at said vertical deflection frequency for attenuating a vertical rate signal of said vertical deflection apparatus.

## Patentansprüche

1. Ablenkvorrichtung für eine Videoanzeige, umfassend:
eine Vertikal-Ablenkschaltung (20) zum Erzeugen eines Vertikal-Ablenkstroms in einer Vertikal-Ablenkwicklung (LV) zum Verändern der Position eines Elektronenstrahls in einer vertikalen Richtung;
eine Horizontal-Ablenkschaltung (60) zum Erzeugen eines Horizontal-Ablenkstroms in einer Horizontal-Ablenkwicklung mit einer Horizontal-Ablenkfrequenz zum Verändern der Position des Elektronenstrahls in einer horizontalen Richtung; und **gekennzeichnet durch**
ein Filter (40) zum Ankoppeln der Horizontal-Ablenkschaltung an die Vertikal-Ablenkwicklung, wobei das Filter (40) in einem Stromweg zwischen der Vertikal-Ablenkschaltung (60) und der Horizontal-Ablenkschaltung (20) angeordnet ist, um einen korrigierenden Strom in einem **durch** die Vertikal-Ablenkwicklung (LV) gebildeten Stromweg mit einer mit der Horizontal-Ablenkfrequenz zusammenhängenden Frequenz zur Bereitstellung von Rasterfehlerkorrektur zu erzeugen, wobei das Filter (40) von der Vertikal-Ablenkschaltung (60) zu der Horizontal-Ablenkschaltung (20) parasitäre Signalkopplung in einer entgegengesetzten Richtung signifikant dämpft.

2. Ablenkvorrichtung nach Anspruch 1, ferner **dadurch gekennzeichnet, daß** das Filter zum Erzeugen eines korrigierenden Stroms einen korrigierenden Strom erzeugt, der eine Abwärtsneigung, die dem Elektronenstrahl vermittelt wird, während der Elektronenstrahl zwischen einem ersten und einem zweiten seitlichen Rand des Rasters abgelenkt wird, wesentlich reduziert.

3. Ablenkvorrichtung nach Anspruch 1, ferner **dadurch gekennzeichnet, daß** das Filter zum Erzeugen eines korrigierenden Stroms einen korrigierenden Strom erzeugt, der Parallelogramm- und/oder Orthogonalitätsfehler korrigiert.

4. Ablenkvorrichtung nach Anspruch 1, ferner **dadurch gekennzeichnet, daß** das Filter zum Erzeugen eines korrigierenden Stroms einen korrigierenden Strom erzeugt, der eine Horizontal-Abtastrate aufweist.

5. Ablenkvorrichtung nach Anspruch 1, ferner **dadurch gekennzeichnet, daß** die Vertikal-Ablenkschaltung Vertikal-Ablenkung bereitstellt und eine Wicklung eines ersten Transformators enthält und die Horizontal-Ablenkschaltung eine Wicklung eines Horizontal-Zeilentransformators enthält, und wobei das Filter in einen Stromweg zwischen den Transformatoren geschaltet ist.

6. Ablenkvorrichtung nach Anspruch 1, ferner **dadurch gekennzeichnet, daß** das Filter einen Kondensator mit einer bei der Horizontal-Ablenkfrequenz niedrigen Impedanz, um ein Horizontalratensignal ohne wesentliche Dämpfung aus der Horizontal- an die Vertikal-Ablenkvorrichtung anzukoppeln, und einer bei der Vertikal-Ablenkfrequenz hohen Impedanz, um ein Vertikalratensignal der Vertikal-Ablenkvorrichtung zu dämpfen, umfasst.

## Revendications

1. Un appareil de déviation d'écran vidéo comprenant ;
un circuit de déviation verticale (20) pour générer un courant de déviation verticale au niveau d'un enroulement de déviation verticale (LV) afin de faire varier une position d'un faisceau d'électrons dans une direction verticale ;
un circuit de déviation horizontale (60) pour générer un courant de déviation horizontale dans un enroulement de déviation horizontale à une fréquence de déviation horizontale pour faire varier la position dudit faisceau d'électrons dans une direction horizontale ; et **caractérisé par** ;
un filtre (40) pour coupler ledit circuit de déviation horizontale audit enroulement de déviation verticale, ledit filtre (40) étant intercalé dans un chemin de courant entre ledit circuit de déviation verticale (60) et ledit circuit de déviation horizontale (20), pour générer un courant de correction dans un chemin de courant formé par ledit enroulement de déviation verticale (LV) à une fréquence liée à ladite fréquence de déviation horizontale pour fournir la correction des erreurs raster, ledit filtre (40) atténuant fortement le couplage de signaux parasite dans une direction opposée, dudit circuit de déviation verticale (60) audit circuit de déviation horizontale (20).

2. L'appareil de déviation selon la revendication 1, **caractérisé en outre en ce que** ledit filtre pour générer un courant de correction génère un courant de correction qui réduit sensiblement une pente descendante transmise audit faisceau d'électrons lorsque ledit faisceau d'électrons est dévié entre des premier et deuxième bords latéraux dudit raster.

3. L'appareil de déviation selon la revendication 1, **caractérisé en outre en ce que** ledit filtre pour générer un courant de correction génère un courant de correction qui corrige au moins l'une des erreurs de parallélogramme et d'orthogonalité.

4. L'appareil de déviation selon la revendication 1, **caractérisé en outre en ce que** ledit filtre pour générer un courant de correction génère un courant de correction qui présente une fréquence de balayage horizontale.

5. L'appareil de déviation selon la revendication 1, **caractérisé en outre en ce que** ledit circuit de déviation verticale fournit une déviation verticale et inclut un enroulement d'un premier transformateur et ledit circuit horizontal inclut un enroulement d'un transformateur de balayage horizontal et dans lequel ledit filtre est couplé dans un chemin de courant entre lesdits transformateurs.

6. L'appareil de déviation selon la revendication 1, **caractérisé en outre en ce que** ledit filtre comprend un condensateur ayant une faible impédance à ladite fréquence de déviation horizontale pour coupler un signal à fréquence horizontale dudit appareil de déviation horizontale audit appareil de déviation horizontale sans atténuation significative et une impédance élevée à ladite fréquence de déviation verticale pour l'atténuation d'un signal à fréquence verticale dudit appareil de déviation verticale.
